(19) Europäisches Patentamt / European Patent Office / Office européen des brevets

(11) **EP 1 763 707 B1**

(12) # EUROPÄISCHE PATENTSCHRIFT

(45) Veröffentlichungstag und Bekanntmachung des Hinweises auf die Patenterteilung:
**12.10.2011 Patentblatt 2011/41**

(21) Anmeldenummer: **05717163.9**

(22) Anmeldetag: **30.03.2005**

(51) Int Cl.:
*G03F 7/20* (2006.01)     *H01J 37/317* (2006.01)
*G11B 11/00* (2006.01)

(86) Internationale Anmeldenummer:
**PCT/EP2005/051451**

(87) Internationale Veröffentlichungsnummer:
**WO 2005/098544 (20.10.2005 Gazette 2005/42)**

(54) **Verfahren zur Erzeugung von Resistprofilen**

method for producing resist profiles

Procédé poru réaliser des profiles dans des photorésistes

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **08.04.2004 DE 102004018147**

(43) Veröffentlichungstag der Anmeldung:
**21.03.2007 Patentblatt 2007/12**

(73) Patentinhaber:
• **Giesecke & Devrient GmbH**
  **81677 München (DE)**
• **Vistec Electron Beam GmbH**
  **07745 Jena (DE)**

(72) Erfinder:
• **KAULE, Wittich**
  **82275 Emmering (DE)**
• **PLONTKE, Rainer**
  **99441 Magdala (DE)**
• **STOLLBERG, Ines**
  **07743 Jena (DE)**
• **SCHUBERT, Andreas**
  **99510 Niederrossla (DE)**
• **DICHTL, Marius**
  **81371 München (DE)**

(74) Vertreter: **Reichert, Werner Franz**
**Reichert & Kollegen**
**Bismarckplatz 8**
**93047 Regensburg (DE)**

(56) Entgegenhaltungen:
• **KLEY E-B ET AL: "E-BEAM LITHOGRAPHY: A SUITABLE TECHNOLOGY FOR FABRICATION OF HIGH-ACCURACY 2D AND 3D SURFACE PROFILES" PROCEEDINGS OF THE SPIE, SPIE, BELLINGHAM, VA, US, Bd. 2640, 23. Oktober 1995 (1995-10-23), Seiten 71-80, XP009031977 ISSN: 0277-786X**
• **SCHNABEL B ET AL: "FABRICATION AND APPLICATION OF SUBWAVELENGTH GRATINGS" PROCEEDINGS OF THE SPIE, SPIE, BELLINGHAM, VA, US, Bd. 3008, 10. Februar 1997 (1997-02-10), Seiten 233-241, XP009031976 ISSN: 0277-786X**
• **HEIDENREICH R D ET AL: "Electron scattering and line profiles in negative electron resists" JOURNAL OF VACUUM SCIENCE AND TECHNOLOGY USA, Bd. 12, Nr. 6, November 1976 (1976-11), Seiten 1284-1288, XP002375481 ISSN: 0022-5355**
• **LIN L H: "Cross-section profiles of single-scan negative electron-resist lines" JOURNAL OF VACUUM SCIENCE AND TECHNOLOGY USA, Bd. 12, Nr. 6, November 1976 (1976-11), Seiten 1289-1293, XP002375482 ISSN: 0022-5355**
• **JAGDHOLD U ET AL: "60 nm copper lines produced by a lift-off technique with 5 keV electrons: experiment and simulation" PROCEEDINGS OF THE SPIE - THE INTERNATIONAL SOCIETY FOR OPTICAL ENGINEERING SPIE-INT. SOC. OPT. ENG USA, Bd. 3049, 1997, Seiten 757-764, XP002375483 ISSN: 0277-786X**

- HAM Y-M ET AL: "APPLICATION OF A NEW EMPIRICAL MODEL TO THE ELECTRON BEAM LITHOGRAPHY PROCESS WITH CHEMICALLY AMPLIFIED RESIST" JAPANESE JOURNAL OF APPLIED PHYSICS, JAPAN SOCIETY OF APPLIED PHYSICS, TOKYO, JP, Bd. 37, Nr. 12B, Dezember 1998 (1998-12), Seiten 6761-6766, XP000880252 ISSN: 0021-4922

- WITTIG L-CHR ET AL: "Intermittence effect in electron beam writing" MICROELECTRONIC ENGINEERING, ELSEVIER PUBLISHERS BV., AMSTERDAM, NL, Bd. 57-58, September 2001 (2001-09), Seiten 321-326, XP004302280 ISSN: 0167-9317

**Beschreibung**

Die Erfindung betrifft ein Verfahren zur Erzeugung von Resistprofilen. Hinzu kommt eine Verwendung des Verfahrens zur Erzeugung von Resistprofilen.

Bisher werden mit Hilfe der Elektronenstrahllithografie in der Halbleiterindustrie Resistschichten strukturiert. Diese strukturierten Resistschichten dienen als Hilfsmasken zur Strukturierung des darunter liegenden Substrates. Dementsprechend werden von dem Resistprofil möglichst steile (rechtwinklig zur Substratoberfläche) Kanten gefordert.

Die deutsche Offenlegungsschrift 41 13 027.8 offenbart ein Verfahren und eine Vorrichtung, mit der Gittermaßstäbe beliebiger Länge mit einer Gitterkonstante im μm-Bereich hergestellt werden können. Ein Vorlagenmaßstab wird zunächst schrittweise fortlaufend auf ein flexibles, mit einem Photoresist beschichtetes Metallband abgebildet. Ein mit der Abbildungsvorrichtung gekoppelter Sensor detektiert die Strukturen in dem belichteten Photoresist. Abwechselnd einschaltbare Haltevorrichtungen für das flexible Metallband an der Abbildungsvorrichtung und dem Tisch der Abbildungsvorrichtung führen durch Relativverschiebung zwischen Abbildungsvorrichtung und Tisch nacheinander weitere Abschnitte des Metallbandes in den Abbildungsbereich. Vom Sensor abgeleitete Steuersignale gewährleisten dabei einen phasenrichtigen Anschluss der Abbildungen des Vorlagengitters.

Das europäische Patent 0 648 343 offenbart eine Fresnel-Linse und ein Verfahren zu deren Herstellung. Es wird mit einem Elektronenstrahl gearbeitet, dessen rechteckiger Strahlquerschnitt veränderbar ist. Da die Veränderungen schnell vorgenommen werden, kann man hiermit eine abgestufte Fresnel-Linse herstellen. Elektronenstrahldosen, die denjenigen von Zylinderlinsen entsprechen, werden übereinander in den Resist belichtet. Jede beliebige Linsenform kann dadurch hergestellt werden. Je feiner die Strukturen werden, desto problematischer ist es, mit der mehrfachen Belichtung glatte Flanken der Strukturen zu erzeugen.

Das Dokument von Kley et al.; SPIE Vol. 2640, S. 71-80, offenbart die Herstellung von Oberflächenprofilen mittels der Elektronenstrahl-Lithographie. Es gibt zwei Systeme, mit welchen die Profile in einem Resist geschrieben werden können. Zum einen ist dies ein System, welches mit variabler Strahlform arbeitet. Zum anderen existiert ein System, welches mit einem Elektronenstrahl arbeitet, welches eine gaußsche Verteilung der Elektronen am Auftreffort besitzt. Für die Herstellung von gebogenen oder gekrümmten Strukturen wird die kontinuierliche Wegkontrolle in Verbindung mit der Bezier Datenbeschreibung verwendet. Dies führt zu weichen Profilen. Es ist möglich, die Strukturen in einem positiven Resist oder in einem negativen Resist zu schreiben.

Das Dokument von Brünger, Kley et al.; Microelc. Eng. 27, S. 135-138 (1995)) offenbart die Herstellung von Gittern mittels der Elektronenstrahl-Lithographie. Hierbei wird besonders der Schwerpunkt auf die Herstellung, von binären Gittern mit einer Periode im Bereich von ungefähr 100 nm bis ungefähr 400 nm gelegt. Mit der Schreibstrategie der kontinuierlichen Wegkontrolle ist es möglich, zirkuläre Gitter in einen für den Elektronenstrahl empfindlichen Resist zu schreiben.

Das Dokument von Heidenreich et al.; J. Vac.Sci.B, 12(6), S.1284-1288 (1975) offenbart eine Abhandlung über die Elektronenstreuung und lineare Profile bei der Verwendung eines negativen Resists für Elektronenstrahlen.

Das Dokument von Lin, L.H.; J. Vac.Sci.B, 12(6), S.1289-1293 (1975) offenbart die experimentellen Ergebnisse, wenn mit einem Elektronenstrahl eine Linie in einem Negativresist geschrieben wird. Das Profil der Linie ist parabolisch, falls die Belichtungsdosis, die anfängliche Dicke des Resists und der Radius des Elektronenstrahls in geeigneter Weise ausgewählt werden.

Das Dokument von Jaghold et al.; SPIE Vol. 3049, S. 757-764) offenbart eine Lift-off-Technik, welche Strukturen unterhalb von 100 nm aus einer metallisierten Schicht herstellt. Hierzu wird eine einzige Schicht eines Resists verwendet, welche mit einem Elektronenstrahl geringer Spannung bestrahlt wird. Eine minimale Strukturgröße von 60 nm kann erzielt werden, wenn eine Beschleunigungsspannung von 5 kV und eine Resistdicke von 120 nm verwendet wird.

Das Dokument von Ham et al.; Jpn. Jnl. Phys. 37, S. 6761-6766 (1998) offenbart die Anwendung eines neuen empirischen Modells zur Elektronenstrahl-Lithographie, wobei chemisch verstärkte Resists verwendet werden. Es wird ein Simulationsmodell vorgestellt, um ein genaues Resistprofil für hochsensitive und kontrastreiche Resists zu erhalten.

Das Dokument von Wittig et al.; Microelc. Eng. 57-58, S. 321-326 (2001) offenbart die Untersuchungen bzgl. der Elektronenstrahlbelichtung von PNA- und HEBS-Glasmasken. Es hat sich gezeigt, dass ein Schreiben mit einem Elektronenstrahl von variabler Strahlform der Unterbrechungseffekt zu nicht einheitlichen Resistprofilen führt. Dieses Schreibkonzept ist somit nicht ausreichend, die Kalibrierkurve wie bei einem Elektronenstrahl mit gaußschem Strahlprofil zu messen.

Der Erfindung liegt die Aufgabe zugrunde, ein Verfahren zu schaffen, mit dem unterschiedliche Resistprofile erzeugbar sind, und dass dem Anwender die Möglichkeit der Modellierung der Resistprofile in die Hand gegeben wird.

Diese Aufgabe wird durch ein Verfahren mit den Merkmalen des Anspruchs 1 gelöst.

Es ist vorteilhaft, wenn die Resistschicht einen Negativresist umfasst. Das Resistprofil umfasst eine Gitterstruktur, die aus einer parallelen Aneinanderreihung von Vertiefungen und Erhöhungen besteht. Die Primärenergie des Elektronenstrahls des Systems zur Elektronenstrahllithographie ist einstellbar, wobei die untere Grenze der Primärenergie 1 KeV und die obere Grenze der Primärenergie 20KeV beträgt. Die Dicke der Resistschicht liegt zwischen 100nm und 500nm. Die Elektronenflächendosis hängt von der Primärenergie des Elektronenstrahls, der Elektronenstreuung in der Resistschicht, der Sondengröße und der Elektronendosis ab.

Es ist von Vorteil, wenn das Verfahren zur Erzeugung von Resistprofilen ein System zur Elektronenstrahllithographie umfasst, das einen Elektronenstrahl erzeugt. Dabei steht die Strahlachse im Wesentlichen senkrecht auf einer Resistschicht, in der das Resistprofil erzeugbar ist. Der Elektronenstrahl ist hinsichtlich der Elektronenflächendosis derart einstellbar, dass aufgrund der Bestrahlung durch den Elektronenstrahl ein Resistprofil erzeugbar ist, das ein nicht-rechtwinkliges Resistprofil aufweist.

Die Resistschicht kann auf einem Substrat aufgebracht sein. Ebenso ist er denkbar, dass die Resistschicht ohne Substrat verwendet wird, und dass in einem oberen Bereich der Resistschicht das Resistprofile erzeugt wird.

Die Elektronenflächendosis wird durch die Parameter, wie Substratart, Resistart, Resistdicke, Entwicklungsvorschrift und der Primärenergie des Elektronenstrahls definiert, und dass die Einstellung des Elektronenstrahls somit entsprechend dieser Parameter vorgenommen wird, um das gewünschte Resistprofil zu erzeugen. Das Resistprofil umfasst eine Gitterstruktur, die aus einer Aneinanderreihung von Vertiefungen und Erhöhungen besteht. Die Höhe der Primärenergie des Elektronenstrahls legt einen Durchmesser einer Streubirne in der Resistschicht um den Einfallort des Elektronenstrahls fest, wobei der Durchmesser der Streubirne umgekehrt proportional zur Primärenergie des Elektronenstrahls ist. Die Ausnutzung des Effekts der Sekundärelektronen im Zusammenspiel mit dem Negativresist ermöglicht die Erzeugung von nicht-rechtwinkligen Resistprofilen.

Die Sondengröße ist quasi-kontinuierlich einstellbar. Das Profil in der Resistschicht ist mit einer einzigen Sondengröße schreibbar, wobei die Sondengröße kleiner als die kleinstmögliche Strukturgröße ist.

Weitere vorteilhafte Ausgestaltungen der Erfindung können den Unteransprüchen entnommen werden.

In der Zeichnung ist der Erfindungsgegenstand schematisch dargestellt und wird anhand der Figuren nachfolgend beschrieben. Dabei zeigen:

Fig. 1 eine schematische Darstellung des Aufbaus eines gesamten Systems zur Elektronenstrahllithographie ;

Fig. 2a eine schematische Darstellung der Streuung eines Elektronenstrahls mit hoher Primärenergie in der Resistschicht;

Fig. 2b eine Draufsicht auf die Oberfläche der Resistschicht und der Projektion des Elektronenstrahls aus Fig. 2a auf die Resistschicht;

Fig. 2c eine schematische Darstellung der Streuung eines Elektronenstrahls mit niedriger Primärenergie in der Resistschicht;

Fig. 2d eine Draufsicht auf die Oberfläche der Resistschicht und der Projektion des Elektronenstrahls aus Fig. 2c auf die Resistschicht;

Fig. 3 ein durch Bestrahlung mit einem Elektronenstrahl erzeugtes, rechtwinkliges Profil gemäß dem Stand der Technik;

Fig. 4 eine Ansicht eines Dreiecksprofils, das mit der gegenwärtigen Erfindung erzeugbar ist;

Fig. 5 eine Ansicht eines sinusförmigen Profils, das mit der gegenwärtigen Erfindung erzeugbar ist;

Fig. 6 eine Ansicht eines trapezförmigen Profils, das mit der gegenwärtigen Erfindung erzeugbar ist;

Fig. 7 eine Darstellung der Erzeugung eines Elements der Gitterstruktur mit n aneinander gereihten Belichtungsschritten zur Erzeugung von nicht rechtwinkligen Resiststrukturen gemäß dem Stand der Technik: und

Fig. 8 eine schematische Darstellung der Erzeugung eines Resistprofils mit flächiger Ausdehnung gemäß der Erfindung.

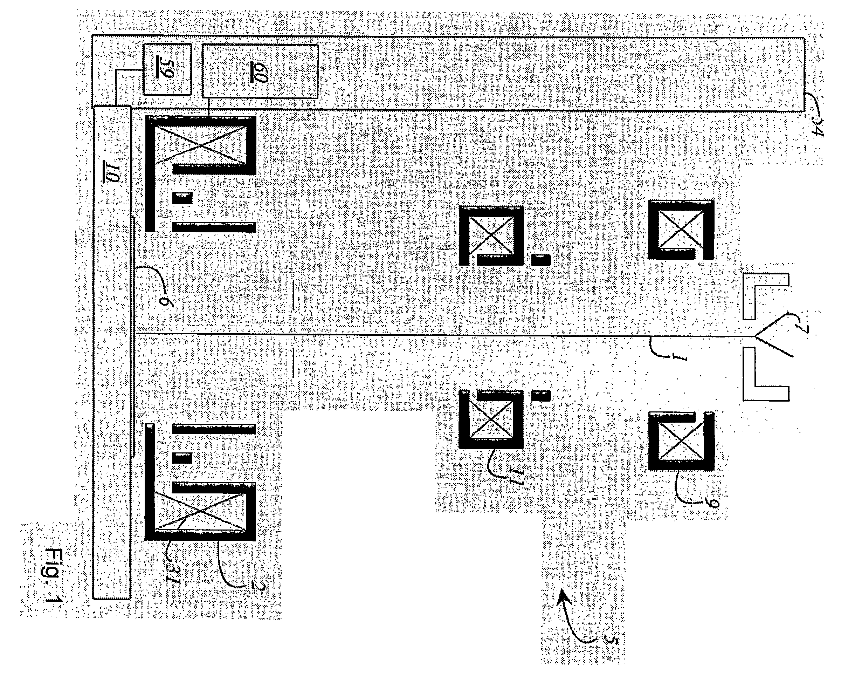

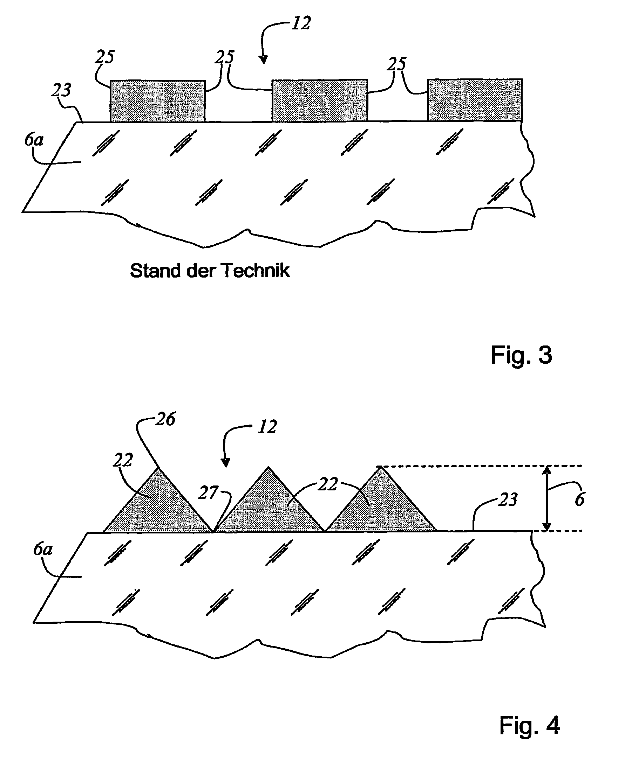

Fig. 1 veranschaulicht die Struktur einer Elektronenstrahlsäule 5, in der der Elektronenstrahl 1 von einer eine Strahlquelle bildenden Elektronenkanone 7 erzeugt wird, wobei er durch eine Kondensorlinse 9 zur Objektivlinse 2 und demgemäß zu einer Resistschicht 6 hindurch läuft. In der Regel ist die Resistschicht 6 auf einem Substrat 6a (siehe Fig. 4 bis Fig. 6) aufgebracht. Obwohl sich die nachstehende Beschreibung auf Elektronenstrahlen beschränkt, ist es einem Fachmann klar, dass auch alle anderen Teilchenstrahlen mit geladenen Partikeln hier Anwendung finden können. Die Anordnung verfügt über ein Steuerungssystem 54. Ebenso ist es möglich, dass ein Resistprofil direkt in der Resistschicht ohne ein Substrat erzeugt wird.

Außerdem wird zum Bearbeiten (Elektronenstrahl-Lithographie) verschiedener Teile der Resistschicht 6 der Elektronenstrahl 1 über die Resistschicht 6 gerastert bzw. bewegt. Für begrenzte Abrasterbereiche kann das Abrastern durch eine Abrastereinrichtung 11 unter Steuerung durch eine Abrastersteuerungseinrichtung 60 erzielt werden. Für größere Bewegungen sorgt die Tischsteuerung 59 dafür, dass der Tisch 10, und damit die Resistschicht 6, horizontal verstellt wird. Das Steuerungssystem 54 wird durch einen Steuerungscomputer (nicht dargestellt) gesteuert.

Die gesamte Einrichtung zur Erzeugung von Resistprofilen umfasst ein System aus der bereits beschriebenen Elektronenstrahlsäule und der Resistschicht 6. Dabei erhält man durch die Abstimmung der Primärenergie des Elektronenstrahls und der Art der verwendeten Resistschicht 6 eine Elektronendichteverteilung im Abstand vom Bestrahlungsort. Der Elektronenstrahl 1 und folglich somit auch die Elektronenstrahlsäule 3 sind hinsichtlich der Elektronenflächendosis derart einstellbar, dass aufgrund der Bestrahlung durch den Elektronenstrahl ein Resistprofil 12 erzeugbar ist, das ein nicht-rechtwinkliges Resistprofil 12 aufweist. Durch den Energieeintrag des Elektronenstrahls 1 während der Elektronenstrahlbelichtung wird die Lösungsgeschwindigkeit des bestrahlten Resists in einem Lösungsmittel verändert. Der auf die Resistschicht 6 treffende Elektronenstrahl 1 wird gestreut und die Streuung ist abhängig von der Primärenergie des Elektronenstrahls 1.

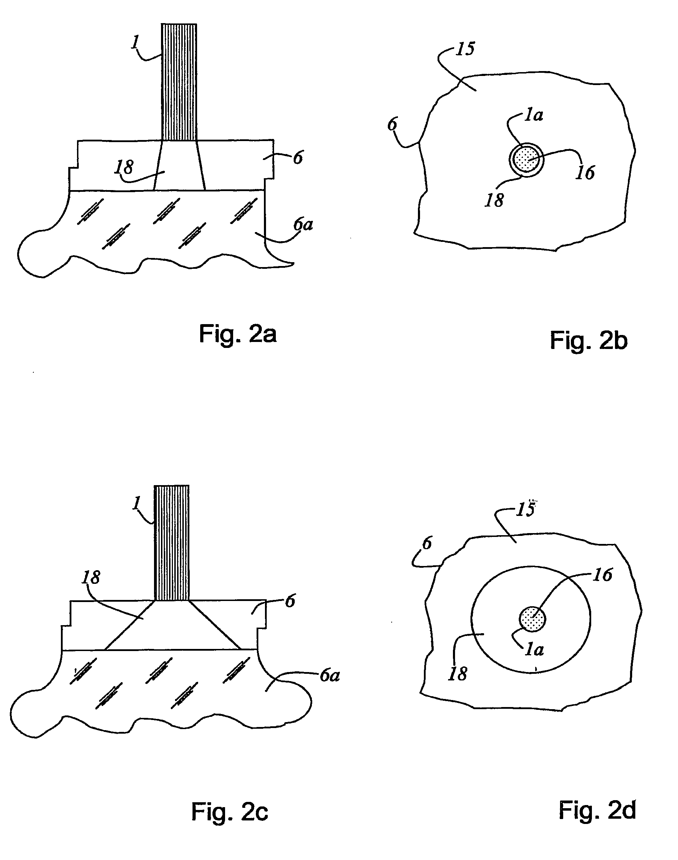

Fig. 2a zeigt eine schematische Darstellung der Streuung eines Elektronenstrahls mit hoher Primärenergie in der Resistschicht 6. Je höher die Primärenergie des Elektronenstrahls 1 ist, desto kleiner ist die Streuung des Elektronenstrahls 1 in der Resistschicht 6. Der Elektronenstrahl 1 trifft auf die Resistschicht 6 und besitzt an der Oberfläche 15 des Resists eine Sondengröße 1a mit einem bestimmten Durchmesser 16 (siehe Fig. 2b).

Durch die Streuung entsteht in der Resistschicht 6 eine Streubirne 18, so dass eine räumlich ausgedehnte Beeinflussung des Resists erfolgt. Die Resistschicht 6 besteht aus einem Negativresist. Dies bedeutet, dass je höher die auf die Resist einwirkende Elektronenenergie ist, desto mehr nimmt die Löslichkeit des Resists durch das Lösungsmittel ab.

In Fig. 2c ist eine schematische Darstellung der Streuung eines Elektronenstrahls 1 mit niedriger Primärenergie in der Resistschicht 6 gezeigt. Die Streubirne 18 besitzt aufgrund der niederen Primärenergie des Elektronenstrahls 1 einen größeren Durchmesser als in Fig. 2a dargestellt ist. Durch die Streuung der Elektronen in der Resistschicht 6 weitet sich der Elektronenstrahl stärker auf als im Vergleich zum Durchmesser des Elektronenstrahl 1 direkt an der Oberfläche 15 der Resistschicht 6 (siehe Fig. 2d). Die Sondengröße 1a des Elektronenstrahls ist in Fig. 2b und Fig. 2b als ein Kreis dargestellt. Die Darstellung der Sondengröße 1a als Kreis soll nicht als eine Beschränkung aufgefasst werden. Andere Projektionen des Elektronenstrahls 1 auf die Oberfläche 15 der Resistschicht 6 sind möglich und die Darstellung eines Kreises wie in der Fig. 2b und Fig. 2c soll ebenfalls nicht als Beschränkung aufgefasst werden.

Wie in der Fig. 2a und Fig. 2b dargestellt, werden durch die Streuung des Elektranenstrahls 1 Bereiche der Resistschicht von Elektronen beeinflusst, die nicht unmittelbar vom Elektronenstrahl getroffen werden. Dieser im allgemeinen negative Sachverhalt ist unter der Bezeichnung Proximity-Effekt bekannt. Bei der Erfindung wird dieser Sachverhalt ausgenutzt. Wie bereits oben erwähnt, ist die Größe und die Form der Streubime 18 nicht alleine auf eine Kegelform 18a beschränkt. Größe und Form der Streubirne 18, innerhalb der die Elektronen Reaktionen in der Resistschicht auslösen, hängt unter anderem auch von der Primärenergie des Elektronenstrahls 1 ab. Mit abnehmender Energie des Elektronenstrahls wird der Durchmesser der Streubirne 18 größer, andererseits verringert sich infolge der geringeren Eindringtiefe die Zahl der aus dem Resist rückgestreuten Elektronen. Mit der Wahl der Primärenergie des Elektronenstrahls 1 kann somit in gewissen Grenzen eine Etektronendichteverteilung eingestellt werden.

Die Sondengröße 1a erweist sich als weiterer Parameter für die Modellierung der Resistprofile. Wird die in der Regel geringe Sondengröße 1a mit Hilfe der gerätetechnischen Steuerung vergrößert, so wirkt das in der Resistschicht 6 wie eine physikalische Integration mehrerer nebeneinander liegender feiner Sonden und damit wie eine Superposition der einzelnen Streubimen 18. Insbesondere bei der Herstellung von Beugungsgittern kann damit erreicht werden, dass ähnliche Profile für einen weiten Bereich von Gitterkonstanten hergestellt werden können.

Die Elektronendosis ist ein dritter Parameter. Mit Hilfe der gewählten Stromdichte des Elektronenstrahls 1 und der Belichtungszeit, kann die Elektronendosis eingestellt werden. Hiermit wird letztendlich die Größe der Streubirne 18 bestimmt, innerhalb derer es zu wirksamen Reaktionen mit dem für die Elektronen des Elektronenstrahls 1 empfindlichen Resist kommt.

Der Elektronenstrahl 1 wird hinsichtlich der Elektronenflächendosis derart eingestellt, dass aufgrund der Bestrahlung durch den Elektronenstrahl ein Resistprofil erzeugbar ist, das ein nicht-rechtwinkliges Resistprofil aufweist. Hierzu wird mit den oben erwähnten Parametern ein Energiedichte-Profil in der Resistschicht 6 erzeugt. Entscheidend ist-nun, dass man einen Resist benutzt, der dieses Elektronendichte-Profil in ein geeignetes Lösungsgeschwindigkeits-Profil in der Resistschicht 6 wandelt.

In Fig. 3 ist das durch einen Elektronenstrahl erzeugte Resistprofil 12 in einer Resistschicht 6 dargestellt. Diese gemäß dem Stand der Technik erzeugten Resistprofile dienen in der Halbleiterindustrie üblicherweise als Hilfsmasken für die Strukturierung eines darunter liegendeh Substrats. Dementsprechend werden von dem Resistprofil möglichst steile (rechtwinklig zur Substratoberfläche) Kanten 25 gefordert und somit auch erzeugt. Die Kanten 25 sind rechtwinklig zur Substratoberfläche 23.

Fig. 4 bis Fig. 6 offenbart Resistprofile 12, die ein nicht-rechtwinkliges Resistprofil 12 aufweisen. Fig. 4 zeigt die Ansicht eines Dreiecksprofils 22, das mit der gegenwärtigen Erfindung erzeugbar ist. Die Seitenkanten des Dreiecksprofils 22 stehen nicht senkrecht auf der Substratoberfläche 23. Es gilt somit einen Resist zu wählen, der das gewählte Elektronendichte-Profil in ein geeignetes Lösungsgeschwindigkeits-Profil wandelt, damit die in der Fig. 4 bis Fig. 6 dargestellten Resistprofile 12 erzeugbar sind. Der Resist der Resistschicht 6 umfasst einen Negativresist und besitzt eine möglichst lineare Gradation, so dass die Elektronendichte-Verteilung in der Resistschicht 6 möglichst feinstufig in eine Löslichkeitsverteilung der Resistschicht 6 transferiert wird. Letztendlich besteht das Resistprofil 12 aus einer Gitterstruktur, die eine parallele Aneinanderreihung von Vertiefungen 27 und Erhöhungen 26 umfasst.

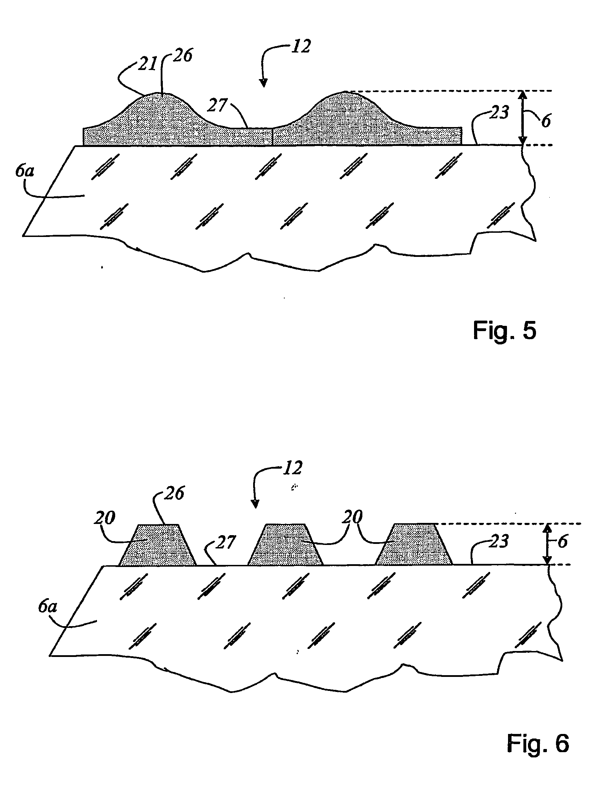

Fig. 5 zeigt ein sinusförmiges Profil 21, das mit der gegenwärtigen Erfindung erzeugbar ist

Fig. 6 zeigt eine Ansicht eines trapezförmigen Profils 20, das mit der gegenwärtigen Erfindung erzeugbar ist.

Wie aus Fig. 4 bis Fig. 6 ersichtlich ist, kann typischerweise ein Strukturelement in einem Belichtungsschritt geschrieben werden. Das Resistprofil 6 umfasst eine Gitterstruktur 24, die aus einer parallelen Aneinanderreihung von Vertiefungen 27 und Erhöhungen 26 besteht. In einem Belichtungsschritt wird also immer eine Erhöhung 26 geschrieben. Wie bereits oben erwähnt, ist die Erhöhung erst nach der Behandlung der Resistschicht 6 mit einem Lösungsmittel sichtbar. Mehrere parallel zueinander angeordnete und voneinander beabstandete Erhöhungen 26 ergeben zusammen die Gitterstruktur 24. Ein Element der Gitterstruktur 24 wird z.B. als ein Gitterstab 35 bezeichnet, der in einem Belichtungsschritt 30 gemäß der gegenwärtigen Erfindung erzeugbar ist..

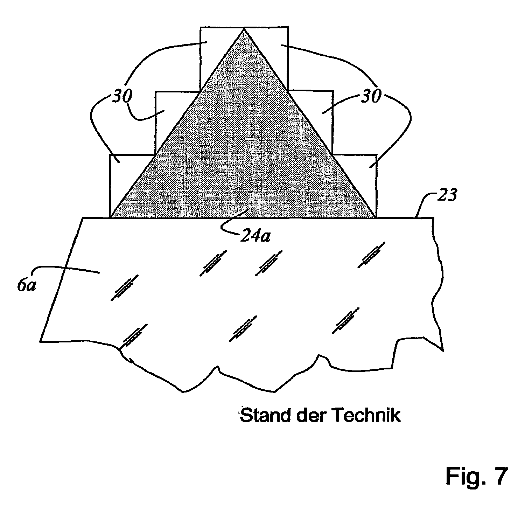

Fig. 7 zeigt eine Darstellung der Erzeugung eines Elements 24a der Gitterstruktur 24 mit n aneinander gereihten Belichtungsschritten 30 zur Erzeugung von nicht rechtwinkligen Reststrukturen gemäß dem Stand der Technik. Zur Erzeugung einer Gitterstruktur aus N Elementen 24a sind somit N x n Belichtungsschritte notwendig. Die einzelnen Belichtungsschriften 30 werden zeitlich nebeneinander belichtet und es ist selbstverständlich, dass eine Lagegenauigkeit der einzelnen Schritte zueinander eingehalten werden muss. Hierbei ist die Größe und die Auswirkung der Streubirne 18 in der Resistschicht zu berücksichtigen, so dass eine gewisse Überdeckungsgenauigkeit eingehalten werden muss. Wird die Überdeckungsgenauigkeit nicht eingehalten, kann dies zu einer Verschlechterung der Strukturtreue bzw. Uniformity analoger Strukturen führen. Hinzu kommt, dass für die Erzeugung eines Elements 24a nach dieser Art und Weise und somit für die gesamte Struktur eine längere Bearbeitungszeit aufgewendet werden muss.

Wie bereits oben beschrieben, ist zur Erzeugung der nicht rechtwinkligen Strukturen in der Resistschicht 6 ein Elektronenstrahl-Lithografiegerät 1 notwendig. Das Elektronenstrahl-Lithografiegerät ermöglicht mit unterschiedlichen Energien der Primärelektronen zu arbeiten. Dabei müssen insbesondere auch solche Energien der Primärelektronen anwendbar sein, bei denen die Eindringtiefe der Primärelektronen in organische Resiste in der Größenordnung der typischerweise verwendeten Resistdicken liegt (100 nm ... 500nm). Die untere Energiegrenze der Primärelektronen sollte bei etwa 1 keV liegen, eine obere Energiegrenze der Primärelektronen sollte bei 20keV ausreichend sein. Die Primärenergie muss sich kontinuierlich oder wenigstens in kleinen Schritten (quasikontinuierlich) ändern fassen.

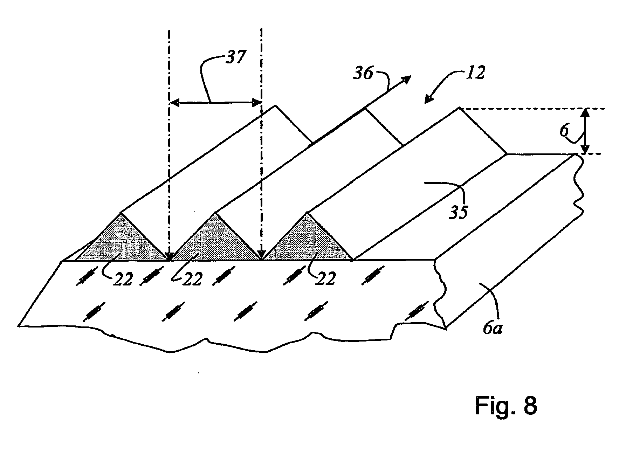

Fig. 8 zeigt eine schematische Darstellung der Erzeugung eines Resistprofils 12 mit einer flächigen Ausdehnung gemäß der Erfindung. Aufgrund der Einfachheit der zeichnerischen Darstellung wird das Dreiecksprofil 22 gewählt. Dies soll jedoch nicht als eine Beschränkung aufgefasst werden. Die flächige Ausdehnung des Resistprofils 12 umfasst mehrere Strukturelemente, von denen jedes Element als Gitterstab 35 bezeichnet wird. Aufgrund der Bestrahlung der Resistschicht 6 durch den Elektronenstrahl erhält man nach der Entwicklung der Resistschicht 6 ein flächiges Resistprofil 12. Zum Erzeugen des Resistprofils 12 wandert der Elektronenstrahl in mehreren Schritten, über die Resistschicht 6. Der Pfeil 36 definiert einen Schritt durch den jeweils ein Gitterstab 35 erzeugt wird. Die Breite des Gitterstabes 35 ist durch den Doppelpfeil 37 gekennzeichnet.

Für die Anwendung können sowohl Elektronenstrahl-Lithographiegeräte verwendet werden, die nach dem Punktstrahlprinzip *(GAUSSIAN beam)* oder dem Formstrahlprinzip *(variable shaped beam)* arbeiten. Entscheidend sind lediglich zwei Dinge. Die Sondengröße 1a muss sich über einen gewissen Bereich quasikontinuierlich ändern lassen. Die minimale Sondengröße 1a muss kleiner als oder klein gegen die minimal zu erzeugenden Strukturelemente sein. Nach dem Punktstahlprinzip arbeitende Geräte für die Nanolithographie (Sondengröße kleiner oder gleich 5nm) sind für diese Anwendung prädestiniert, aber nicht zwingend nötig.

Das Elektronenstrahl-Lithographiegerät 1 muss in den zur Anwendung kommenden Belichtungsregimen über die Möglichkeit einer feinfühligen Dosissteuerung verfügen. Dies ist üblicherweise erfüllt und geschieht über die Belichtungszeit (Bildpunktzeit, dwell-time, shot-rate) bzw. die Belichtungsgeschwindigkeit bei bewegtem Substrat.

Bei dem verwendeten Resist muss es sich um einen Negativresist handeln, d.h. die mit Elektronen bestrahlten Teile des Resists müssen gegenüber dem Entwickler bzw. Lösungsmittel (bei einer bestimmten Temperatur, einer bestimmten Konzentration, einer bestimmten Einwirkzeit) eine schlechtere Löslichkeit haben als der unbestrahlte Resist Zur weiteren Charakteristik wird Bezug auf die Kontrastkurve des Resists genommen. Die Kontrastkurve erhält man, wenn man bei sonst konstanten Bedingungen (Energie der Primärelektronen, Entwicklungsprozess, Ausgangsdicke $d_0$ der Resistschicht 6) die nach der Entwicklung verbliebene Dicke der Resistschicht 6 über der angewendeten Elektronen-Flächendosis $D$ aufträgt. Um zu verallgemeinerten Aussagen zu kommen, ist es zweckmäßig, zu einer normierten Kontrastkurve überzugehen, bei der die verbliebene Dicke der Resistschicht 6 auf die Ausgangsdicke $d_0$ der Resistschicht 6 bezogen wird und die angewendete Elektronendosis auf den maximalen Dosiswert $D_{max}$, ab dem kein Abtrag der Resistschicht 6 mehr erfolgt. Der Resist hat eine für das Verfahren hinreichend weiche Gradation, wenn die Steilheit S , dieser gemäß Gleichung (1) dargestellten Kurve den Wert von 1,5 nicht überschreitet.

$$S = (\frac{\Delta d}{d_0}) / (\frac{\Delta D}{D_{max}}) \qquad \text{Gleichung 1}$$

Resiste einschließlich eines geeigneten Entwicklungsverfahren, die diese Bedingung erfüllen, sind vorhanden und kommerziell erhältlich. Die normierte Elektronenflächendosis ist der Quotient der angewendeten Elektronenflächendosis und der maximalen Elektronenflächendosis. Die maximale Elektronenflächendosis ist diejenige Elektronenflächendosis, bei der im Entwicklungsprozess kein Abtrag des Resists erfolgt.

Um für das ausgewählte Resistsystem (Substrat, Resist, Dicke der Resistschicht 6, Entwicklungsvorschrift, Energie der Primärelektronen) die Kontrastkurve zu bestimmen, wird wie folgt vorgegangen. Zunächst werden Flächen (von z.B. 50μm X 100μm) mit unterschiedlicher Dosis belichtet. Nach der Entwicklung wird, wie z.B. mit einem Tastschnittgerät, die verbliebene Dicke der Resistschicht 6 gemessen und daraus die Kontrastkurve ermittelt, die für das weitere Vorgehen benötigt wird. Das Verfahren ist für mehrere infrage kommende Elektronenenergien zu wiederholen.

Ebenso gilt es für die spätere definierte Einstellung des Systems die Streubirne 18 und dessen Größe zu ermitteln. Es wird das bereits ausgewählte System aus Substrat, Resist, Dicke der Resistschicht 6, Entwicklungsvorschrift und Energie der Primärelektronen benutzt In die Resistschicht 6 werden nun Einzellinien geschrieben, wobei am Elektronenstrahl-Lithographiegerät die kleinstmögliche Sondengröße eingestellt wird. Verwendet wird dafür wenigstens der maximale Dosiswert $D_{max}$. Es ist jedoch zweckmäßig, wie aus dem folgenden ersichtlich wird, auch höhere Werte zu benutzen, sowie Einzellinien zu Strichgruppen mit unterschiedlichen Gitterkonstanten zu gruppieren. Nach dem Prozessieren des Substrates wird dasselbe senkrecht zu den Linien gebrochen und mit Hilfe eines Rasterelektronenmikroskops (nicht dargestellt) der Querschnitt bzw. das Linienprofil ermittelt. Damit erhält man in Abhängigkeit vom Einfallort des Elektronenstrahles eine Resist-Restdickenverteilung. Diese Resistdickenverteilung kann man mit Hilfe der Kontrastkurve in eine dort wirksame Elektronendosisverteilung umrechnen. Diese Elektronendosisverteilung ist die Streubirne 18. Dies ergibt insgesamt für das betrachtete System die wirksame Elektronendichte in Abhängigkeit vom Einstrahlort bzw. Einfallort der Elektronen. Da einzelne Linien benutzt wurden, kann dies mit einer eindimensionalen Funktion, wie z. B. in Gleichung (2), dargestellt werden.

$$D = D_0 \times f(x) \qquad \text{Gleichung 2}$$

Mit dieser Basisfunktion kann nun einfach durch Superposition das Ergebnis berechnet werden, das sich ergibt, wenn ein Gitter belichtet wird. Mit anderen Worten bedeutet dies, dass die Belichtung eines benachbarten Gitterstabes in dem Bereich erfolgt, wo die Dosis des zuvor oder danach belichteten Gitterstabes noch eine endliche Größe aufweist. Auf die gleiche Weise kann auch eine andere, größere Elektronensonde simuliert werden. Die in der obigen Vorschrift empfohlenen Gitter bzw. breiteren Linien dienen nun quasi der experimentellen Überprüfung der theoretischen Vorhersagen. Sie sind also nicht unbedingt nötig, erhöhen aber die Genauigkeit der Bestimmung von D = D(x) und damit die Signifikanz der Vorhersage. Für eine reale Gitterstruktur erhält man also die Elektronendichteverteilung eines Gitterstabes durch Summation, was in Gleichung (3) wiedergegeben ist

$$D_{result} = D_0 \times [f_e(x) + f_e(x-g) + f_e(x+g)] \qquad \text{Gleichung (3)}$$

Gleichung 3 gilt, wenn die Gitterstabe mit der kleinstmöglichen Sonde geschrieben werden. Ein Profil eines einzelnen Gitterstabes, der mit einer Sonde mit einer Breite B größer als die kleinstmögliche Breite $b$ geschrieben wird, wie z.B. $B = (2n+1) \times b$, erhält man danach gemäß Gleichung 4:

$$D_B = \left(\frac{D_0}{(2n+1)}\right) \times \sum_{i=1}^{i=n} [f_e(x) + f_e(x - i \times b) + f_e(x + i \times b)] \quad \text{Gleichung (4)}$$

Wenn in Gleichung (3) statt $D_0$ der in Gleichung (4) bestimmte Wert $D_B$ verwendet wird, kann man also auch Gitteranordnungen berechnen bei denen die Stäbe nicht mit der kleinstmöglichen Sonde belichtet werden.

Mit Hilfe der Kontrastkurve wird die Elektronendichte nun wiederum umgerechnet in eine Schichtdickenverteilung. Durch Variation der Parameter ($D_0$,g,b) und Auswahl der Energie $f_e(x)$ kann nun die Variante ausgesucht werden, die dem gewünschten Profil am besten entspricht.

Nachstehend sich drei Beispiele für die Anwendung der nicht rechtwinkligen Resistprofile aufgelistet

**Beispiel 1: CD- DVD- Super-DVD**

Bei diesen Speichermedien ist die Information in so genannten "Pits" und "Lands" enthalten. Pits und Lands sind entlang einer Spur angeordnet und wechseln einander ab. Sie unterscheiden sich in ihrer Länge. Pits sind gegenüber ihrer Umgebung erhaben. Beim Lesen wird das Speichermedium von einem fokussierten Laserstrahl abgetastet. Dabei ist der Laser-Spot typischerweise etwa dreimal so groß im Durchmesser wie die Pits breit sind. Dies dient dem Zentrieren des Spots beim Abtasten des Mediums.

Da bei CDs und DVDs zum Schreiben des Masters ebenfalls Laser verwendet werden, bedeutet das, dass bei Ausnutzung eines minimalen Spot-Durchmessers die Medien nur dreimal gröber geschrieben werden können als es möglich wäre, sie nachher auszulesen. So ist es nahe liegend, den Elektronenstrahl zur Masterherstellung einzusetzen, um so die Grenze des optisch Auslesbaren zu erreichen. Nun ist es aber so, dass die Signalentstehung nicht an den erhabenen Flächen der Pits und Lands entsteht, sondern an deren Flanken. Und gerade der Flankenwinkel entscheidet über die Signalhöhe bzw. Signalgüte und damit über die Sicherheit des Auslesens bzw. die Auslesegeschwindigkeit. Mit dem von uns beschriebenem Verfahren könnte also die gewünschte Trapezform des Querschnittes der Pits optimal eingestellt werden.

**Beispiel 2: Maßstäbe für Längenmessmaschinen**

In Positioniersystemen höchster Genauigkeit werden zur Koordinatenbestimmung heutzutage zwei Verfahren benutzt, einmal Laserwegmesssysteme, zum anderen das optische Abtasten von Präzisions-Gittermaßstäben. Für letztere ist unser beschriebenes Verfahren hilfreich. Beim Messen wird der bewegte Maßstab von einem Laser bestrahlt und das gebeugte Licht mit Sensoren registriert. Die dabei registrierten Maxima und Minima der Intensität des gebeugten Lichtes werden gezählt, mit der Gitterkonstante verrechnet ergibt das dann die Strecke, um welche das System mit dem fest verbundenen Maßstab verschoben worden ist Wenn das Profil (Querschnitt des Gitters) nun in geeigneter Weise gewählt wird, kann man erreichen, dass die gesamte Beugungsintensität nur in eine Beugungsordnung geht, d.h. man erhält eine hohe Signalintensität. Das bedeutet wiederum schnelleres Messen bzw. Positionieren und zuverlässigeres Messen bzw. Positionieren. Sinusgitter haben diese Eigenschaft, und diese Profilmodellierung kann mit dem von uns beschriebenen Verfahren realisiert werden.

**Beispiel 3: Sicherheitshologramme**

Geldscheine, Kreditkarten, Pässe, usw. werden zunehmend mit nicht kopierfähigen Sicherheitsmerkmalen ausgestattet. Dazu gehören auch Hologramme, die mit dem bloßen Auge erkennbar sind, je nach Betrachtungswinkel ihre Farbe und ihr Erscheinungsbild verändern. Physikalisches Element dieser Hologramme sind letztlich wieder beugende Gitterstrukturen. Und auch hier gilt wieder das unter Beispiel 2 Gesagte: wenn das Profil dieser Gitterelemente ein geeignetes ist, z.B. ein sinusförmiges, dann werden diese Sicherheitsmerkmale optisch besonders leuchtkräftig, markant und unverwechselbar. Für maschinelle Auswertung ergeben sich weitere Besonderheiten, die ebenfalls auf der Gitterstruktur beruhen, aber aus verständlichen Gründen nur mit einer gewissen Zurückhaltung offen gelegt werden. Werden also die Master für jene Elemente mit Hilfe des Elektronenstrahles hergestellt, so bietet sich unser Verfahren an, die theoretisch geforderten Eigenschaften praktisch umzusetzen.

**Bezugszeichenliste:**

| 1 | Elektronenstrahl |
|---|---|
| 1a | Sondengröße |
| 2 | Objektivlinse |
| 5 | Elektronenstrahlsäule |
| 6 | Resistschicht |
| 6a | Substrat |
| 7 | Elektronenkanone |
| 8 | Elektronenstrahl |
| 9 | Kondensorlinse |
| 10 | Tisch |
| 11 | Abrastereinrichtung |
| 12 | Resistprofil |
| 15 | Oberfläche |
| 16 | Durchmesser |
| 18 | Streubirne |
| 18a | Kegelform |
| 20 | trapezförmiges Profil |
| 21 | sinusförmiges Profil |
| 22 | Dreiecksprofil |
| 23 | Substratoberfläche |
| 24 | Gitterstruktur |
| 25 | Kanten |
| 26 | Erhöhung |
| 27 | Vertiefung |
| 30 | Belichtungsschritt |
| 35 | Gitterstab |
| 36 | Pfeil |
| 37 | Doppelpfeil |
| 51 | Steuerungscomputer |

54     Steuerungssystem

59     Tischsteuerung

60     Abrastersteuerungseinrichtung

**Patentansprüche**

1. Verfahren zur Erzeugung von Resistprofilen mit einem System zur Elektronenstrahllithographie, das einen Elektronenstrahl (1) mit einer Primärenergie und einer durch den Elektronenstrahl (1) definierten Sondengröße (1a) erzeugt, dessen Strahlachse im wesentlichen senkrecht auf einer Resistschicht (6) steht, in der das Resistprofil erzeugt wird und die einen Negativresist umfasst, wobei das verwendete Elektronenstrahl-Lithographiegerät (5) bei den zur Anwendung kommenden Belichtungsregimen über eine Dosissteuerung verfügt, mit den folgenden Schritten :

   • dass in ein ausgewähltes Resistsystem aus Substrat (6a), Resist (6), und Dicke des Resists (6) mehrere Flächen mit jeweils unterschiedlicher Dosis belichtet werden, wobei nach der Entwicklung die verbliebene Dicke der Resistschicht (6) gemessen und daraus eine Kontrastkurve ermittelt wird;
   • dass für eine spätere definierte Einstellung des Elektronenstrahl-Lithographiegeräts (5) eine Streubirne (18) und deren Größe in Bezug auf das Resistsystem ermittelt wird, wobei hierzu in die Resistschicht (6) Einzellinien mit der kleinstmöglichen Sondengröße des Elektronenstrahl-Lithographiegeräts (5) geschrieben werden, woraus in Abhängigkeit vom Einfallort des Elektronenstrahles (1) eine Resist-Restdickenverteilung ermittelt wird, die mit Hilfe der Kontrastkurve in eine dort wirksame Elektronendosisverteilung umgerechnet wird und die Streubirne (18) darstellt;
   • dass aus der aus der ermittelten Kontrastkurve und aus der Streubirne (18) ermittelten Elektronendosisverteilung eine resultierende Resistdickenverteilung bestimmt wird, die von mehreren Parametern abhängt;
   • dass der für die Bestrahlung der Resistschicht verwendete Elektronenstrahl (1) hinsichtlich der Parameter wie Elektronenflächendosis, Breite des zu erzeugenden Resistprofils, Dicke der Resistschicht (6) und/oder Primärenergie des Elektronenstrahls (1) derart eingestellt wird, dass ein nicht-rechtwinkliges Resistprofil in der Resistschicht (6) erzeugt wird, wobei mit einer einzigen Sondengröße (1 a) geschrieben wird, welche kleiner als die kleinstmögliche Strukturgröße ist, und
   • dass die Sondengröße (1 a) quasi-kontinuierlich eingestellt wird, wobei eine Primärenergie des Elektronenstrahls (1) stufenlos eingestellt wird und die untere Grenze der Primärenergie 1 KeV und die obere Grenze der Primärenergie 20KeV beträgt.

2. Verfahren nach Anspruch 1, **dadurch gekennzeichnet, dass** die Elektronenflächendosis ferner durch die Parameter wie Substratart, Resistart und Entwicklungsvorschrift definiert wird, und dass die Einstellung des Elektronenstrahls (1) ebenfalls entsprechend dieser Parameter vorgenommen wird.

3. Verfahren nach Anspruch 1, **dadurch gekennzeichnet, dass** das Resistprofil eine Gitterstruktur (24) umfasst, die aus einer Aneinanderreihung von Vertiefungen (27) und Erhöhungen (26) besteht.

4. Verfahren nach Anspruch 1, **dadurch gekennzeichnet, dass** bei konstanten Bedingungen der Primärenergie des Elektronenstrahls (1), des Entwicklungsprozesses und der Resistdicke vor der Elektronenbestrahlung eine Gradation des Resists (6) als eine Funktion einer normierten Resistdicke bezogen auf die angewendete normierte Elektronenflächendosis aufgetragen wird, wobei die Gradation $S = (\frac{\Delta d}{d_0}) / (\frac{\Delta D}{D_{max}})$ einen Wert von 1,5 nicht überschreitet.

5. Verfahren nach Anspruch 3, **dadurch gekennzeichnet, dass** ein Element des Profils der Gitterstruktur (24), welche aus Vertiefungen (27) und Erhöhungen (26) besteht, durch die angewendete Elektronenflächendosis

$$D_B = \left(\frac{D_0}{(2n+1)}\right) \times \sum_{i=1}^{i=n} [f_e(x) + f_e(x - i \times b) + f_e(x + i \times b)]$$

bestimmt ist.

6. Verfahren nach einem der Ansprüche 1 bis 5, **dadurch gekennzeichnet, dass** durch die Höhe der Primärenergie des Elektronenstrahls (1) ein Durchmesser einer Streubirne (18) in der Resistschicht (6) um den Einfallort des Elektronenstrahls (1) festgelegt wird, wobei der Durchmesser der Streubirne umgekehrt proportional zur Primärenergie des Elektronenstrahls (1) ist.

7. Verwendung des Verfahrens zur Erzeugung von Resistprofilen nach einem der Ansprüche 1 bis 6, **dadurch gekennzeichnet, dass** der Elektronenstrahl (1) zur Masterherstellung für CDs oder DVDs verwendet wird, wobei die CDs oder DVDs eine Vielzahl vom Pits und Lands aufweisen, und dass eine gewünschte Trapezform des Querschnittes der Pits eingestellt wird.

8. Verwendung des Verfahrens zur Erzeugung von Resistprofilen nach einem der Ansprüche 1 bis 6, **dadurch gekennzeichnet, dass** mit dem Elektronenstrahl (1) Präzisions-Gittermaßstäbe hergestellt werden, und dass das Gitter ein Profil eines Sinusgitters aufweist.

9. Verwendung des Verfahrens zur Erzeugung von Resistprofilen nach einem der Ansprüche 1 bis 6, **dadurch gekennzeichnet, dass** der Elektronenstrahl (1) zur Herstellung von Gitterstrukturen (24) für Sicherheitsmerkmale verwendet wird, und dass das Gitter ein Profil eines Sinusgitters aufweist.

## Claims

1. A process for creating resist profiles with a system for electron beam lithography which generates an electron beam (1) with a primary energy and a probe size (1a) defined by the electron beam (1) whose beam axis is primarily normal to a resist layer (6), in which the resist profile is generated and which comprises a negative resist, the electron beam lithography device (5) used for the exposure regime in question being fitted with an irradiation controller, with the following steps:

   • that in a selected resist system consisting of a substrate (6a), resist (6), and the thickness of the resist (6), a number of surfaces are irradiated each with a different dose, with, wherein after development, the remaining thickness of the resist layer (6) being measured and a contrast curve being determined on the basis thereof;
   • that for a later defined setting of the electron beam lithography device (5) an electron diffusion volume (18) and its size is determined with reference to the resist system, to do this, individual lines with the smallest possible probe size of the electron beam lithography device (5) being drawn into the resist layer (6), based upon which a resist residual thickness distribution is determined dependent on the point of incidence of the electron beam (1), which is converted with the aid of the contrast curve into an electron dosage distribution which is effective there and represents the electron diffusion volume (18);
   • that a resultant resist thickness distribution is determined based on the electron dosage distribution determined from the determined contrast curve and the electron diffusion volume (18), which depends on a number of parameters;
   • that the electron beam (1) used to irradiate the resist layer is adjusted in such a way as concerns parameters such as the electron surface dose, the width of the resist profile to be generated, the thickness of the resist layer (6) and/or the primary energy of the electron beam (1) that a non-normal resist profile is generated in resist layer (6), drawing taking place with a single probe size (1a) which is smaller than the smallest possible structure size; and
   • that the probe size (1a) is adjusted to be quasi-continuous, a primary energy of the electron beam (1) being infinitely adjusted and the lower limit of the primary energy is 1 KeV and the upper limit of the primary energy is 20KeV.

2. A process according to Claim 1 **characterized in that** the electron surface dose is furthermore defined by parameters such as the type of substrate used, type of resist and the development regulation, and that the setting of the electron beam (1) is also undertaken according to these parameters.

3. A process according to Claim 1 **characterized in that** the resist profile comprises a grid structure (24) which in turn consists of a sequence of depressions (27) and ridges (26).

4. A process according to Claim 1 **characterized in that** for constant conditions of the primary energy of the electron beam (1), the development process and the resist thickness before irradiation with electrons, a gradation of the resist (6) is spread as a function of a standardized resist thickness based on the standardized electron surface dose used, the gradation $S = \dfrac{\left(\dfrac{\Delta d}{d_o}\right)}{\square\left(\dfrac{\Delta D}{D_{\max}\square}\right)}$ not exceeding a value of 1.5.

5. A process according to Claim 3 **characterized in that** an element of the profile of the grid structure (24) exists, which consists of depressions (27) and ridges (26), through which the electron surface dose used

$$D_B = \left(\frac{D_8}{2_n + 1}\right) \times \sum_{i=1}^{i=n}[f_e(x) + f_e(x - i \times b) + f_e(x + i \times b)]$$ is determined.

6. A process according to one of the claims 1 to 5 **characterized in that** a diameter of a electron diffusion volume (18) in the resist layer (6) around the point of incidence of the electron beam (1) is established by the level of the primary energy of the electron beam (1), the diameter of the electron diffusion volume being inversely proportional to the primary energy of the electron beam (1).

7. Use of the process to generate resist profiles according to one of the claims 1 to 6 **characterized in that** the electron beam (1) is used for master production of CDs or DVDs, the CDs or DVDs having a number of pits and lands and that a desired trapezoid form of the cross-section of the pits is set.

8. Use of the process to generate resist profiles according to one of the claims 1 to 6 **characterized in that** precision index gratings (measurement scales) are manufactured with the electron beam (1) and that the grid has a profile of a sinusoidal grid.

9. Use of the process to generate resist profiles according to one of the claims 1 to 6 **characterized in that** the electron beam (1) for manufacture of grid structures (24) is used for safety features and that the grid has a profile of a sinusoidal grid.

**Revendications**

1. Procédé de production de profils résist avec un système de lithographie par faisceaux d'électrons qui génère un faisceau d'électrons (1) avec une énergie primaire et une taille de sonde (1 a) définie par le faisceau d'électrons (1) dont l'axe de rayonnement est sensiblement perpendiculaire à une couche résist (6) dans laquelle le profil résist est généré et qui comprend un résist négatif, étant donné que l'appareil lithographique à faisceaux d'électrons (5) utilisé dispose pour les régimes d'exposition appliqués d'une commande de dosage, avec les étapes suivantes :

• dans un système résist sélectionné se composant du substrat (6a), de la couche résist (6), et de l'épaisseur de la couche résist (6), plusieurs surfaces sont exposées avec chaque fois une dose différente, étant donné que, après le développement, l'épaisseur restante de la couche résist (6) est mesurée et une courbe de contraste est déterminée sur la base de cette mesure ;
• pour un réglage ultérieur défini de l'appareil lithographique à faisceaux d'électrons (5), on détermine un nuage de diffusion (18) et sa taille par rapport au système résist, étant donné que, à cet effet, des lignes individuelles avec la plus petite taille de sonde possible de l'appareil lithographique à faisceaux d'électrons (5) sont écrites dans la couche résist (6), ce à partir de quoi une distribution d'épaisseur résiduelle de couche résist est déterminée en fonction du lieu d'incidence du faisceau d'électrons (1), distribution qui est convertie en une distribution de dose d'électrons qui y est effective à l'aide de la courbe de contraste et représente le nuage de diffusion (18) ;
• à partir de la distribution de dose d'électrons déterminée à partir de la courbe de contraste et du nuage de diffusion (18), on détermine une distribution d'épaisseur résist résultante qui est fonction de plusieurs paramètres ;
• les paramètres du faisceau d'électrons (1) utilisé pour le rayonnement de la couche résist, paramètres comme la dose de surface d'électrons, la largeur du profil résist à générer, l'épaisseur de la couche résist (6) et/ou l'énergie primaire du faisceau d'électrons (1) sont réglés de manière à ce qu'un profil résist non orthogonal soit généré dans la couche résist (6), étant donné que l'écriture se fait avec une seule taille de sonde (1 a) qui est plus petite que la taille de structure la plus petite possible ; et

• la taille de sonde (1 a) est réglée quasi continuellement, étant donné qu'une énergie primaire du faisceau d'électrons (1) est réglée progressivement et la limite inférieure de l'énergie primaire est 1 KeV et la limite supérieure de l'énergie primaire est 20 KeV.

2. Procédé selon la revendication 1, **caractérisé en ce que** la dose de surface d'électrons est en outre définie par les paramètres comme le type de substrat, le type de couche résist et la directive de développement, et **en ce que** le réglage du faisceau d'électrons (1) se fait également conformément à ces paramètres.

3. Procédé selon la revendication 1, **caractérisé en ce que** le profil résist comprend une structure réticulaire (24) qui se compose d'une rangée de creux (27) et bosses (26).

4. Procédé selon la revendication 1, **caractérisé en ce que**, l'énergie primaire du faisceau d'électrons (1), le processus de développement et l'épaisseur de couche résist avant le rayonnement électronique étant donnés dans des conditions constantes, une gradation de la couche résist (6) est appliquée comme fonction d'une épaisseur de couche résist normée par rapport à la dose de surface d'électrons normée utilisée, étant donné que la gradation

$$S = \frac{\left(\frac{\Delta d}{d_o}\right)}{\square}\left(\frac{\Delta D}{D_{max}\square}\right)$$ ne dépasse pas une valeur de 1,5.

5. Procédé selon la revendication 3, **caractérisé en ce qu'**un élément du profil de la structure réticulaire (24) se composant de creux (27) et bosses (26) est défini par la dose de surface d'électrons appliquée

$$D_B = \left(\frac{D_B}{2_n + 1}\right) \times \sum_{i=1}^{i=n}[f_s(x) + f_s(x - i \times b) + f_s(x + i \times b)]$$ .

6. Procédé selon l'une quelconque des revendications 1 à 5, **caractérisé en ce qu'**un diamètre d'un nuage de diffusion (18) est défini dans la couche résist (6) par la valeur de l'énergie primaire du faisceau d'électrons (1) autour du lieu d'incidence du faisceau d'électrons (1), étant donné que le diamètre du nuage de diffusion est inversement proportionnel à l'énergie primaire du faisceau d'électrons (1).

7. Utilisation du procédé de production de profils résist selon l'une quelconque des revendications 1 à 6, **caractérisé en ce que** le faisceau d'électrons (1) est utilisé pour la fabrication de masters pour CDs ou DVDs, étant donné que les CDs ou DVDs présentent une pluralité de pits et lands, et **en ce qu'**une forme trapézoïdale souhaitée de la coupe transversale des pits est réglée.

8. Utilisation du procédé de production de profils résist selon l'une quelconque des revendications 1 à 6, **caractérisée en ce que** des échelles réticulaires de précision sont fabriquées avec le faisceau d'électrons (1), et **en ce que** le réseau présente un profil de réseau sinusoïdal.

9. Utilisation du procédé de production de profils résist selon l'une quelconque des revendications 1 à 6, **caractérisée en ce que** le faisceau d'électrons (1) est utilisé pour la fabrication de structures réticulaires (24) pour caractéristiques de sécurité, et **en ce que** le réseau présente un profil de réseau sinusoïdal.

Fig. 1

Fig. 2a

Fig. 2b

Fig. 2c

Fig. 2d

*25* *25* *12* *25*

*23*

*6a*

**Stand der Technik**

**Fig. 3**

*26* *12*

*22* *27* *22* *22* *23* *6*

*6a*

**Fig. 4**

Fig. 5

Fig. 6

Stand der Technik

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4113027
- EP 0648343 A

**In der Beschreibung aufgeführte Nicht-Patentliteratur**

- **Kley et al.** *SPIE,* vol. 2640, 71-80
- **Brünger, Kley et al.** *Microelc. Eng.,* 1995, vol. 27, 135-138
- **Heidenreich et al.** *J. Vac.Sci.B,* 1975, vol. 12 (6), 1284-1288
- **Lin, L.H.** *J. Vac.Sci.B,* 1975, vol. 12 (6), 1289-1293
- **Jaghold et al.** *SPIE,* vol. 3049, 757-764
- **Ham et al.** *Jpn. Jnl. Phys.,* 1998, vol. 37, 6761-6766
- **Wittig et al.** *Microelc. Eng.,* 2001, vol. 57-58, 321-326